# DEMANDE DE BREVET EUROPEEN

(11) **EP 0 550 360 A1**
(43) Date de publication de la demande: **07.07.1993**
(21) Numéro de dépôt: 92420486.0
(22) Date de dépôt: 29.12.1992
(51) Int. Cl.: H03L 7/095, G06F 7/64

(54) **Détecteur de verrouillage d'une boucle à verrouillage de phase**

(30) Priorité: 02.01.1992 FR 9200139
(71) Demandeur: SGS-THOMSON MICROELECTRONICS S.A., F-94250 Gentilly (FR)
(72) Inventeur: Bonnot, Jean-Louis, F-38340 Voreppe (FR)
(74) Mandataire: de Beaumont, Michel

(57) **Abrégé**

Détecteur de verrouillage d'une boucle à verrouillage de phase (PLL) dans laquelle est généré un signal d'erreur de phase (y) représentatif de la différence de phase entre un signal de référence (Fref) et un signal (F) à verrouiller sur le signal de référence. Le détecteur comprend des moyens (42) permettant de fournir la dérivée (φ') du signal d'erreur de phase (φ) et un comparateur (44) activant un signal de détection de verrouillage (LD) lorsque l'amplitude de ladite dérivée (φ') est inférieure à un seuil prédéterminé (φ'0). Les moyens comprennent un compteur/décompteur (54) pour compter et décompter une horloge de fréquence élevée par rapport à la fréquence d'impulsions d'erreur de phase générées par le détecteur de phase de la PLL. Le mode comptage ou décomptage du compteur est commuté alternativement de l'un à l'autre à chaque impulsion d'erreur de phase. Le compteur contient donc la somme des différences de largeur des impulsions successives générées par le détecteur de phase.

## Description

La présente invention concerne les boucles à verrouillage de phase (PLL) dites à "pompe de charge" et en particulier un détecteur de verrouillage permettant d'indiquer, dans un synthétiseur de fréquence muni d'un tel PLL, si une fréquence de sortie instantanée est voisine d'une fréquence de référence sur laquelle la fréquence de sortie doit être verrouillée.

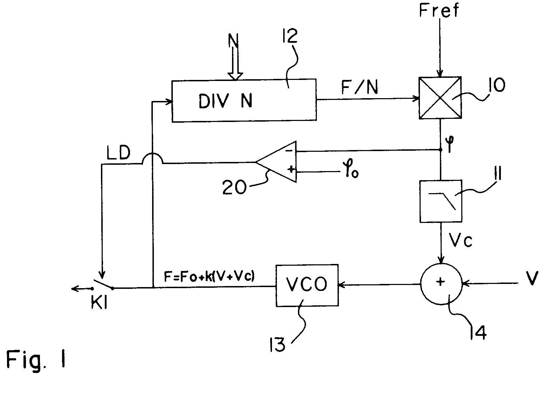

La figure 1 illustre schématiquement un synthétiseur de fréquence à PLL muni d'un détecteur de verrouillage. De tels synthétiseurs de fréquence sont souvent utilisés dans des émetteurs radio, comme, par exemple, les émetteurs d'un poste de téléphoné sans fil (émetteur du poste vers le combiné et émetteur du combiné vers le poste). Dans la suite de la description, on se basera sur cet exemple.

Le synthétiseur de fréquence à PLL de la figure 1 comprend un comparateur de phase 10 recevant un signal rectangulaire de fréquence Fref constante et un signal rectangulaire de fréquence F/N. Ce comparateur 10 délivre un signal d'erreur de phase φ à un filtre passe-bas 11. La fréquence F/N provient de la division par N d'une fréquence F par un diviseur programmable 12. La fréquence F est fournie par un oscillateur commandé en tension (VCO) 13.

Un additionneur 14 fournit au VCO une tension de commande égale à la somme d'une tension V et de la tension Vc fournie par le filtre passe-bas 11. La tension V est une tension alternative modulante basse fréquence correspondant à un signal de parole. La fréquence de coupure de la boucle est suffisamment basse (de l'ordre de 100 Hz) devant la fréquence du signal modulant V pour que la contre réaction apportée par le signal Vc ne puisse pas rattraper les variations de fréquence provoquées par le signal modulant V. Ainsi, la fréquence de sortie instantanée F du VCO, lorsque la boucle est verrouillée, est modulée par la tension V autour d'une fréquence de consigne Fc, ou porteuse, telle que Fc/N = Fref. A tout moment, et en particulier lorsque la boucle est déverrouillée à la suite d'un changement de la fréquence de consigné Fc, la fréquence de sortie instantanée F du VCO vérifie la relation F = F₀ + k(V + Vc), où F₀ est la fréquence de repos fixe du VCO et k le gain du VCO. Le signal de fréquence F, ou porteuse modulée, est émis par une antenne non représentée.

Si un poste de téléphone ne disposait que d'une fréquence porteuse Fc, ou canal, les récepteurs de ce poste, qui fonctionnent avec la même fréquence porteuse, pourraient être parasités par l'existence à proximité d'autres émetteurs de fréquence porteuse voisine. Pour éviter ces parasites, les postes de téléphone sans fil actuels disposent généralement de plusieurs canaux commutables, soit manuellement par l'utilisateur, soit automatiquement avec recherche du canal le moins parasité. Un changement de canal est opéré en reprogrammant le taux de division N du diviseur 12.

Lorqu'on change de canal, la fréquence F₀ de la porteuse varie progressivement pour atteindre la nouvelle valeur. Lors de cette variation, il faut inhiber l'émission car elle entraînerait des parasites sur des récepteurs de fréquence porteuse comprise dans la plage de variation de la fréquence F₀. Pour cela, on prévoit dans les émetteurs à PLL un détecteur de verrouillage qui inhibe l'émission tant que la fréquence porteuse n'est pas suffisamment proche de la nouvelle valeur sélectionnée.

Un détecteur classique comprend un comparateur 20 comparant la valeur absolue de l'erreur de phase φ à une phase de référence φ0 et délivrant un signal de détection de verrouillage LD. Ce signal LD est inactif tant que la valeur absolue de φ est supérieure à φ0, ce qui entraîne la coupure (par un interrupteur symbolique K1) de l'émission de la fréquence F.

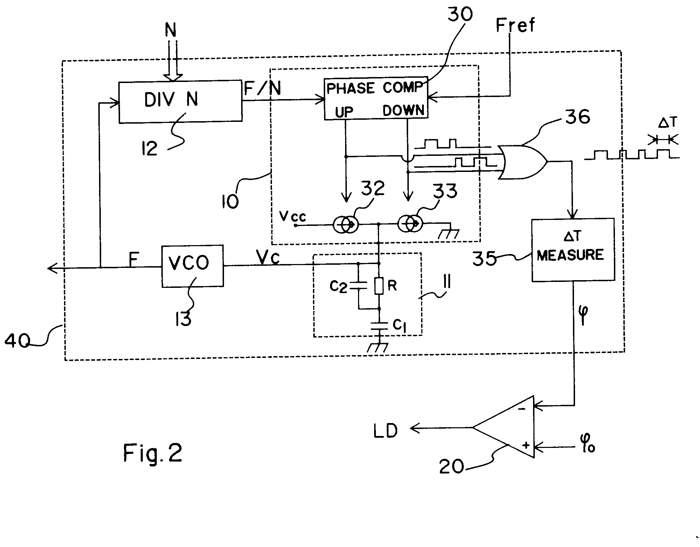

La figure 2 représente plus en détail un PLL à pompe de charge. On y retrouve des mêmes éléments qu'à la figure 1 désignés par des mêmes références. Le comparateur de phase 10 comprend un générateur d'impulsions 30 recevant le signal à la fréquence de référence Fref et le signal à la fréquence F/N de sortie du diviseur 12 et fournissant des impulsions sur l'une ou l'autre de ses sorties UP et DOWN. La sortie UP délivre, lorsque le signal F/N est en retard de phase par rapport au signal Fref, des impulsions dont la largeur ΔT est égale au retard de phase. La sortie DOWN délivre, lorsque le signal F/N est en avance de phase, des impulsions dont la largeur ΔT est égale à l'avance de phase. Les sorties UP et DOWN commandent respectivement des sources de courant 32 et 33 disposées en série entre une tension d'alimentation haute Vcc et une tension d'alimentation basse, telle que la masse. Le point de connexion de ces sources 32 et 33 constitue la sortie du comparateur de phase 10. Sur cette sortie est directement disponible la tension Vc réglant la fréquence de consigne Fc du VCO 13. Le filtre passe-bas 11 comprend une résistance R et une capacité C1 disposées en série entre la sortie du comparateur 10 et la masse et une capacité C₂ branchée aux bornes de la résistance R.

Avec cette configuration, les capacités C₁ et C₂ sont chargées par paliers (la source 32 est commutée à la cadence Fref par un train d'impulsions UP) tant que le signal F/N est en retard de phase par rapport au signal Fref, ce qui entraîne une augmentation de la tension Vc, donc une augmentation de la fréquence F et une diminution du retard de phase. Lorsque le augmentation de la tension Vc, donc une augmentation de la fréquence F et une diminution du retard de phase. Lorsque le signal F/N est en avance de phase, les capacités C₁ et C₂ sont déchargées par paliers (la source 33 est commutée par un train d'impulsions DOWN) et la fréquence F diminue. Et ainsi de suite jusqu'à ce que F/N = Fref.

Pour réaliser une détection de verrouillage, un dispositif de mesure de largeur d'impulsion 35 mesure, à chaque période 1/Fref de la fréquence Fref, la largeur ΔT de chacune des impulsions UP ou DOWN et fournit une valeur proportionnelle à ΔT correspondant à la valeur absolue de l'amplitude du signal d'erreur de phase φ à l'instant de la mesure. Le dispositif 35 comprend pour cela une capacité d'échantillonnage (non représentée) qui est chargée par une source de courant constant pendant la durée de chaque impulsion UP ou DOWN et déchargée brusquement après chaque impulsion. La tension aux bornes de cette capacité est échantillonnée avant chaque décharge, ce qui fournit la valeur absolue de l'erreur de phase φ échantillonnée à la fréquence Fref. L'amplitude de ce signal échantillonné est comparée à une valeur de référence φ0 pour générer le signal de détection de verrouillage LD comme dans la figure 1. Les impulsions UP et DOWN sont fournies au dispositif 35 par l'intermédiaire d'une porte OU 36.

Il est connu de la technique, par exemple du brevet américain 4 410 861, de comparer la valeur absolue de la dérivée φ' du signal φ à une valeur fixe φ'0 pour fournir un signal de détection de verrouillage LD. En procédant ainsi, on obtient une indication de verrouillage lorsque l'écart de fréquence par rapport à une valeur réglée est inférieur à une valeur fixe, quel que soit le saut de fréquence. Ceci permet d'éviter des parasitages de canaux voisins, notamment lorsque les sauts de fréquence sont de faible amplitude.

Le dérivateur du brevet susmentionné pourrait être utilisé dans un PLL à pompe de charge en reliant son entrée à la sortie du dispositif 35. Toutefois, ce dérivateur nécessite des capacités de valeur importante qui ne sont pas intégrables.

Un objet de la présente invention est de réaliser un dérivateur pour PLL à pompe de charge qui soit entièrement intégrable.

Cet objet est atteint grâce à un dérivateur d'un signal ayant une amplitude proportionnelle aux largeurs d'impulsions successives d'une succession d'impulsions, comprenant des moyens pour fournir, après chaque série d'un nombre pair prédéterminé d'impulsions, une valeur de sortie correspondant à la somme des différences de largeur des impulsions de ladite série.

Selon un mode de réalisation de la présente invention, les moyens pour fournir la valeur de sortie comprennent : une porte logique recevant sur une entrée les impulsions, et sur une autre entrée, un signal ayant une fréquence grande par rapport à la fréquence des impulsions ; un compteur/décompteur recevant le signal de sortie de la porte logique et fournissant la valeur de sortie ; et un séquenceur pour commuter le mode de comptage ou de décomptage du compteur à chaque impulsion et pour remettre à zéro le compteur à la fin d'un nombre pair des impulsions.

Selon un mode de réalisation de la présente invention, le signal à dériver est un signal d'erreur de phase d'une boucle à verrouillage de phase à pompe de charge dans laquelle une capacité est successivement soumise à des impulsions de charge ou de décharge formant la succession d'impulsions.

La présente invention prévoit également un détecteur de verrouillage pour un PLL à pompe de charge. Ce détecteur comprend un comparateur à fenêtre numérique recevant sur une première entrée le contenu dudit compteur/décompteur et sur une deuxième entrée une valeur seuil, et fournissant un signal de détection de verrouillage actif quand la valeur absolue du contenu du compteur est inférieure à la valeur seuil.

Un avantage de la présente invention est qu'un dispositif de mesure de largeur d'impulsion, comprenant une capacité d'échantillonnage non intégrable, n'est plus nécessaire.

Ces objets, caractéristiques et avantages ainsi que d'autres de la présente invention seront exposés en détail dans la description suivante de modes de réalisation particuliers faite en relation avec les figures jointes parmi lesquelles :
la figure 1, précédemment décrite, illustre une architecture classique de synthétiseur de fréquence à boucle à verrouillage de phase (PLL) incorporant un détecteur de verrouillage ;
la figure 2 représente une architecture classique de synthétiseur de fréquence à PLL à pompe de charge incorporant un détecteur de verrouillage ;
la figure 3 représente sous forme de blocs un mode de réalisation de dérivateur selon l'invention adapté à un synthétiseur à PLL à pompe de charge.
la figure 4 représente un type de comparateur particulier utilisé dans le circuit de la figure 3 ; et
la figure 5 représente sous forme de blocs un mode de réalisation du comparateur de la figure 4.

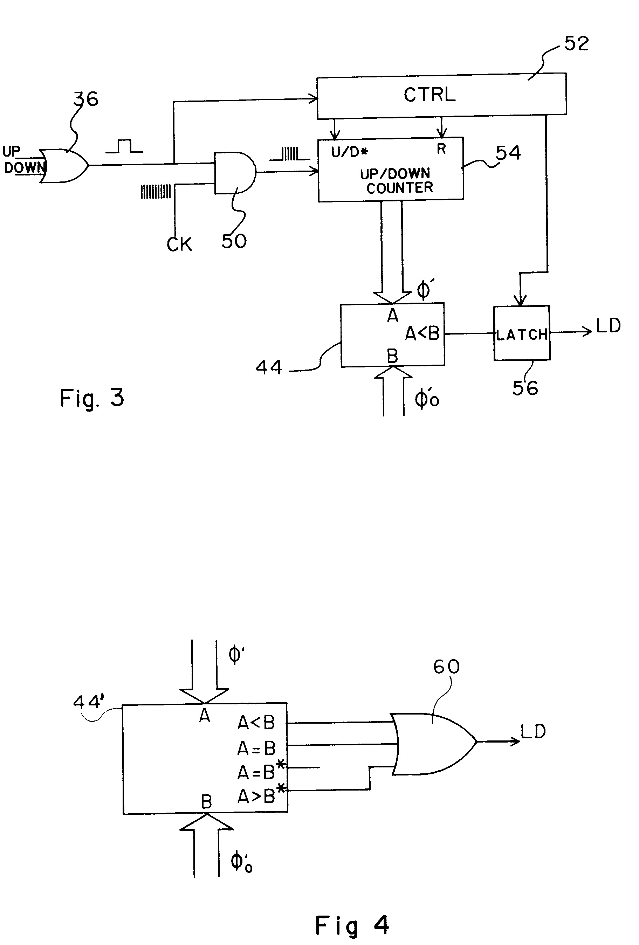

Le dérivateur selon l'invention de la figure 3 permet de dériver l'erreur de phase directement à partir des impulsions UP et DOWN fournies par le circuit 30 du synthétiseur à PLL à pompe de charge de la figure 2.

Le fonctionnement du dérivateur de la figure 3 est basé sur la prise de conscience du fait que la différence de largeur entre deux impulsions UP ou DOWN successives est proportionnelle à la dérivée recherchée φ' à un instant situé entre les deux impulsions successives. En outre, quand la fréquence F est en phase d'approche d'une fréquence de référence FC reprogrammée, les largeurs successives des impulsions UP ou DOWN décroissent et tendent vers zéro. Ainsi, en soustrayant de la largeur d'une première impulsion la largeur de l'impulsion suivante, on obtient des valeurs successives positives dans une phase d'approche. Le circuit de la figure 3 fournit un signal échantillonné Φ' correspondant aux différences susmentionnées.

A la figure 3, on retrouve la porte OU 36 recevant les impulsions UP et DOWN fournies par le générateur 30 de la figure 2. La sortie de cette porte OU 36 est reliée à une entrée d'une porte ET 50 et à l'entrée d'un séquenceur (CTRL) 52. L'autre entrée de la porte ET 50 requit un signal d'horloge CK de fréquence élevée par rapport à la fréquence Fref des impulsions UP ou DOWN. La fréquence du signal CK est par exemple la fréquence de repos F₀ du VCO 13. Avec cette configuration, on obtient à la sortie de la porte ET 50 des trains d'impulsions de fréquence F₀, le nombre d'impulsions de chaque train étant proportionnel aux largeurs des impulsions UP ou DOWN. Ces trains d'impulsions sont fournis à l'entrée d'un compteur/décompteur 54 comprenant en outre une entrée U/D* de basculement en mode comptage ou décomptage, et une entrée de remise à zéro R.

Le séquenceur 52, à chaque front descendant d'une impulsion UP ou DOWN fournie par la porte OU 36, bascule le mode de comptage du compteur 54. Ainsi, le compteur incrémentera, par exemple, son contenu à chaque impulsion d'un premier train d'impulsions fourni par la porte ET 50 et décrémentera son contenu à chaque impulsion d'un deuxième train. Par conséquent, au bout d'un nombre pair d'impulsions UP ou DOWN, le compteur 54 contiendra une valeur, fournie en tant que valeur de sortie Φ' du dérivateur, qui est proportionnelle à la valeur moyenne de la dérivée φ' sur le nombre de couples d'impulsions UP ou DOWN qui se sont produits.

Bien entendu, il faut réinitialiser périodiquement le compteur 54. Le séquenceur 52 effectue cela après chaque série d'un nombre pair d'impulsions UP ou DOWN, le nombre pair étant fixé une fois pour toutes par le séquenceur. Chaque réinitialisation se produit de préférence lorsque le compteur 54 est en mode décomptage, de sorte qu'il se retrouve en mode comptage dès le premier train d'impulsions de la série suivante.

Le contenu Φ' du compteur 54 est fourni à une entrée A d'un comparateur numérique 44. Cette valeur Φ' est comparée à une donnée seuil fixe Φ'₀ fournie à une entrée B du comparateur 44. Ce comparateur 44 fournit un signal A<B à un état actif à une bascule de verrouillage 56 quand Φ' est inférieur à Φ'₀. Après chaque série d'impulsions UP ou DOWN, juste avant la réinitialisation du compteur 54, la bascule 56, validée par le séquenceur 52, transfère la sortie A<B du comparateur 44 en tant que signal de détection de verrouillage LD.

Il y a des cas où les différences successives de largeurs d'impulsions peuvent être négatives. Le contenu du compteur 54 prendrait alors des valeurs binaires négatives qui pourraient être confondues avec des valeurs binaires élevées. Un comparateur classique 44 détecterait alors des fausses conditions de non-verrouillage du PLL. Ceci se produirait, en particulier, car le contenu du compteur 54 présente une fluctuation de ± 1 bit autour de la valeur 0 une fois que le PLL est verrouillé.

La figure 4 représente un comparateur 44' à utiliser en lieu et place du comparateur 44 de la figure 3 pour éviter de telles détections erronées de conditions de non-verrouillage du PLL. Le comparateur 44' est un comparateur à fenêtre numérique ayant des entrées de valeurs A et B, recevant respectivement le contenu du compteur 54 et la valeur seuil Φ'₀, et quatre sorties. Une première sortie A<B est active quand la valeur A est inférieure à la valeur B ; une deuxième sortie A=B est active quand la valeur A est égale à la valeur B ; Une troisième sortie A=B* est active quand la valeur A est égale au complément B* de la valeur B ; et une deuxième sortie A > B* est active quand la valeur A est supérieure au complément B* de la valeur B. Les sorties A<B, A=B et A>B* sont reliées aux entrées d'une porte OU 60 à trois entrées. La porte OU 60 délivre le signal de détection de verrouillage LD à la bascule 56 de la figure 3.

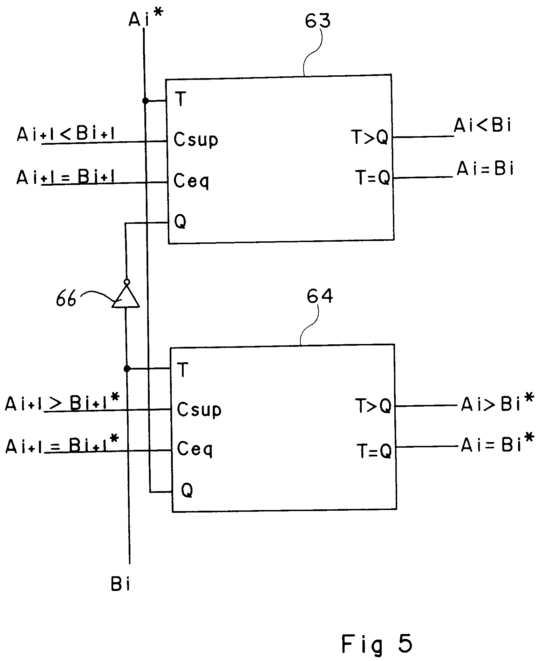

La figure 5 représente un mode de réalisation sous forai de blocs d'une cellule du comparateur à fenêtre numérique 44'. Le comparateur 44' comprend deux comparateurs élémentaires bit à bit 63 et 64 formant une cellule i (i = 0, 1, 2... n) pour chaque bit de poids i Ai et Bi des valeurs d'entrée A et B. Chaque comparateur élémentaire 63, 64 comprend deux entrées de bit T et Q, deux entrées de retenue Csup et Ceq, et deux sorties T>Q et T=Q. Les entrées T des comparateurs élémentaires 63 et 64 reçoivent respectivement le complément Ai* du bit Ai, et le bit Bi. Les entrées Q des comparateurs élémentaires 63 et 64 reçoivent respectivement le complément du bit Bi par un inverseur 66, et le bit Ai*. Les entrées de retenue Csup des comparateurs élémentaires 63 et 64 sont reliées aux sorties T>Q des comparateurs élémentaires correspondants de la cellule i+1. Les entrées de retenue Ceq des comparateurs élémentaires 63 et 64 sont reliées aux sorties T=Q des comparateurs élémentaires correspondants de la cellule i+1.

Les entrées Csup et Ceq de la n^{ième} cellule sont respectivement connectées à des potentiels correspondants aux états logiques 0 et 1.

Chaque comparateur élémentaire 63, 64 est un comparateur bit à bit classique. La table de vérité, indiquant les valeurs des sorties T>Q et T=Q en fonction des valeurs des entrées T, Q, Csup, et Ceq est donnée ci-dessous.

| Csup | Ceq | T | Q | T>Q | T=Q |
|---|---|---|---|---|---|
| 0 | 0 | X | X | 0 | 0 |
| 0 | 1 | 0 | 0 | 0 | 1 |
| 0 | 1 | 0 | 1 | 0 | 0 |
| 0 | 1 | 1 | 0 | 1 | 0 |
| 0 | 1 | 1 | 1 | 0 | 1 |
| 1 | 0 | X | X | 1 | 0 |

Un X dans le tableau indique indifféremment une valeur 0 ou 1.

L'homme du métier notera qu'il existe de nombreuses façons de réaliser le séquenceur 52 avec des circuits logiques, des bascules et des circuits de retard pour réaliser les fonctions décrites.

Bien que l'on ait décrit un dérivateur d'un signal d'erreur de phase dans un PLL à pompe de charge, ce dérivateur selon l'invention sert à trouver la dérivée de tout signal dont l'amplitude est proportionnelle aux largeurs successives d'un train d'impulsions.

## Revendications

1. Dérivateur d'un signal (φ) ayant une amplitude proportionnelle aux largeurs d'impulsions successives d'une succession d'impulsions (UP ou DOWN), comprenant des moyens pour fournir, après chaque série d'un nombre pair prédéterminé d'impulsions, une valeur de sortie (Φ') correspondant à la somme des différences de largeur des impulsions de ladite série.

2. Dérivateur selon la revendication 1, caractérisé en ce que lesdits moyens pour fournir ladite valeur de sortie (Φ') comprennent :
une porte logique (50) recevant sur une entrée lesdites impulsions, et sur une autre entrée, un signal (CK) ayant une fréquence (F₀) grande par rapport à la fréquence (Fref) desdites impulsions ;
un compteur/décompteur (54) recevant le signal de sortie de ladite porte logique (50) et fournissant ladite valeur de sortie (Φ') ; et
un séquenceur (52) pour commuter le mode de comptage ou de décomptage du compteur (54) à chaque impulsion et pour remettre à zéro ledit compteur (54) à la fin d'un nombre pair desdites impulsions.

3. Dérivateur selon la revendication 2, caractérisé en ce que le signal à dériver est un signal d'erreur de phase (Φ) d'une boucle à verrouillage de phase (PLL) à pompe de charge dans laquelle une capacité (C1, C2) est successivement soumise à des impulsions de charge (UP) ou de décharge (DOWN) formant ladite succession d'impulsions.

4. Détecteur de verrouillage pour un PLL à pompe de charge selon la revendication 3, caractérisé en ce qu'il comprend un comparateur à fenêtre numérique (44') recevant sur une première entrée le contenu dudit compteur/décompteur (54) et sur une deuxième entrée une valeur seuil (Φ'₀), et fournissant un signal de détection de verrouillage actif quand la valeur absolue du contenu du compteur est inférieure à la valeur seuil.
